# EUROPEAN PATENT SPECIFICATION

(11) **EP 3 456 797 B1**
(45) Date of publication and mention of the grant of the patent: **17.06.2020**
(21) Application number: 18194842.3
(22) Date of filing: 17.09.2018
(51) Int. Cl.: C09K 11/06, H01L 31/0232, H01L 31/055, H01L 31/054

(54) **FLUORESCENT PROJECTION DISPLAY DEVICE CAPABLE OF PHOTOVOLTAIC GENERATION AND DISPLAY SYSTEM EMPLOYING THE SAME**
ZUR FOTOVOLTAISCHEN ERZEUGUNG FÄHIGE, FLUORESZENTE PROJEKTIONSANZEIGEVORRICHTUNG UND ANZEIGESYSTEM
DISPOSITIF D'AFFICHAGE DE PROJECTION FLUORESCENTE CAPABLE DE GÉNÉRATION PHOTOVOLTAÏQUE ET SYSTÈME D'AFFICHAGE L'UTILISANT

(30) Priority: 18.09.2017 KR 20170119356
(43) Date of publication of application: 20.03.2019
(73) Proprietor: Korea Electronics Technology Institute, Bundang-gu, Seongnam-si Gyeonggi-do 13509 (KR)
(72) Inventor: HAN, Chul-Jong, 16807 Gyeonggi-do (KR); OH, Min-Suk, 06521 Seoul (KR); YOO, Byung-Wook, 05502 Seoul (KR); KIM, Ji-Yong, Chungcheongnam-do (KR); YI, Jeong-Min, Seoul (KR)
(74) Representative: Isarpatent

(56) References cited:
- WO-A1-2016/120264
- US-A1- 2008 149 165
- US-A1- 2008 223 438
- US-A1- 2015 194 555

## Description

### CROSS-REFERENCE TO RELATED APPLICATION

The present application claims the benefit of priority to Korean Patent Application No. 10-2017-0119356, filed on September 18, 2017, in the Korean Intellectual Property Office.

### TECHNICAL FIELD

The present disclosure relates to a fluorescent projection display system and, more particularly, to a fluorescent projection display device capable of generating photovoltaic electricity while performing a projection display function. Also, the present disclosure relates to a display system employing the fluorescent projection a display device.

### BACKGROUND

A luminescent solar concentrator is a device including a transparent waveguide embedding luminescent molecules and a solar cell by attached at an edge of the transparent waveguide to generate electricity from sunlight. Though the research of the luminescent solar concentrator has been at a standstill because of the absence of a suitable luminescent materials having wavelength matching property and reliability, the emergence of quantum dot fluorescent materials has stimulated the research and development of new technologies.

The luminescent solar concentrator may show lower efficiency than a conventional opaque solar cells, but the applications for the luminescent solar concentrator are being contemplated consistently in consideration of its transparent property and resultant functionality. Therefore, efforts are being made to impart additional functionalities to the luminescent solar concentrator.

In US 2015/194555 A1 a luminescent solar concentrator panel is described which can absorb photons from incident light and re-emit them in order to irradiate a solar cell.

US 2008/223438 A1 describes a system for improving luminescent concentrator performance.

WO 2016/120264 A1 describes a concentrated photovoltaic device having a photoluminescent compound in order to absorb and re-emit radiation.

US 2008/0149165 A1 describes a luminescent solar collector with a photocell.

### SUMMARY

According to the present disclosure, provided are a fluorescent projection display device capable of performing both the generation of photovoltaic electricity and the display of visual images, and a display system employing the fluorescent projection display device.

Additional aspects will be set forth in part in the description which follows and, in part, will be apparent from the description, or may be learned by practice of the presented exemplary embodiments.

According to an aspect of the invention, a fluorescent projection display device capable of photovoltaic generation includes: a transparent film including luminescent materials configured to reflect incident sunlight internally to concentrate the incident sunlight, and to be excitated by input light in an excitation wavelength range to radiate a display light corresponding to the light in the excitation wavelength range, wherein the luminescent materials are configured to emit visible light as the display light; and a solar cell disposed on at least one edge of the transparent film to convert concentrated sunlight propagated from the transparent film into electricity.

The fluorescent projection display device may further include a transparent substrate disposed on at least one side of the transparent film to support the transparent film.

The luminescent materials may have sizes of 50 nanometers or smaller and an emission wavelength range of 420-650 nanometers or narrower.

The transparent film may have a transmittance of 30% or higher and a haze of 3% or less.

According to another aspect of the invention, a fluorescent projection display system capable of photovoltaic generation includes: a fluorescent projection display device comprising a transparent film including luminescent materials configured to reflect incident sunlight internally to concentrate the incident sunlight, and to be excitated by input light in an excitation wavelength range to radiate a display light corresponding to the light in the excitation wavelength range, wherein the luminescent materials are configured to emit visible light as the display light, and a solar cell disposed on at least one edge of the transparent film to convert concentrated sunlight propagated from the transparent film into electricity; and a projector configured to radiate a projection beam the excitation wavelength range to the fluorescent projection display device so that the fluorescent projection display device displays an image corresponding to the projection beam.

The excitation wavelength range may be below 420 nm.

The projector may include a light emitting diode or a laser projector as a light source.

The projector may include a digital light processing (DLP) processor or a Galvano scanner as an image forming device.

In the fluorescent projection display device according to the present disclosure, the luminescent materials doped in the transparent film scatter sunlight and are excited by the light in the excitation wavelength range to emit visible light. Also, the solar cell disposed at the edge of the film generates photovoltaic electric energy from the concentrated sunlight from the transparent film. Thus, the fluorescent projection display device according to the present disclosure may perform both the functions of generating electricity by photovoltaic generation and displaying images.

Also, the fluorescent projection display device according to the present disclosure can be used as a window-attachable solar cell because it is transparent and capable of generate photovoltaic electric energy.

Thus, the functional versatility and utility of the fluorescent projection display device according to the present disclosure can be extended to three types of devices: a transparent window, a photovoltaic energy generation device, and a display device that may be used to display a transparent augmented reality image.

### BRIEF DESCRIPTION OF THE DRAWINGS

In order that the disclosure may be well understood, there will now be described various forms thereof, given by way of example, reference being made to the accompanying drawings, in which:
FIG. 1 is an exploded view of a fluorescent projection display device capable of photovoltaic generation according to an embodiment of the present disclosure;
FIG. 2 is a perspective view of the fluorescent projection display device capable of photovoltaic generation of FIG. 1;
FIG. 3 is an enlarged view of a portion A in FIG. 1; and
FIG. 4 schematically illustrates a display system employing the fluorescent projection display device capable of photovoltaic generation according to an embodiment of the present disclosure.

The drawings described herein are for illustration purposes only and are not intended to limit the scope of the present disclosure in any way.

### DETAILED DESCRIPTION

In the following description and the accompanied drawings, detailed descriptions of well-known functions or configuration that may obscure the subject matter of the present disclosure will be omitted for simplicity. It is to be noted that the same components are designated by the same reference numerals throughout the drawings.

The terms and words used in the following description and appended claims are not necessarily to be construed in an ordinary sense or a dictionary meaning, and may be appropriately defined herein to be used as terms for describing the present disclosure in the best way possible. Such terms and words should be construed as meaning and concept consistent with the technical idea of the present disclosure. The embodiments described in this specification and the configurations shown in the drawings are merely preferred embodiments of the present disclosure and are not intended to limit the technical idea of the present disclosure. Therefore, it should be understood that there may exist various equivalents and modifications which may substitute the exemplary embodiments at the time of filing of the present application.

Hereinbelow, exemplary embodiments of the present disclosure will be described in detail with reference to the accompanying drawings.

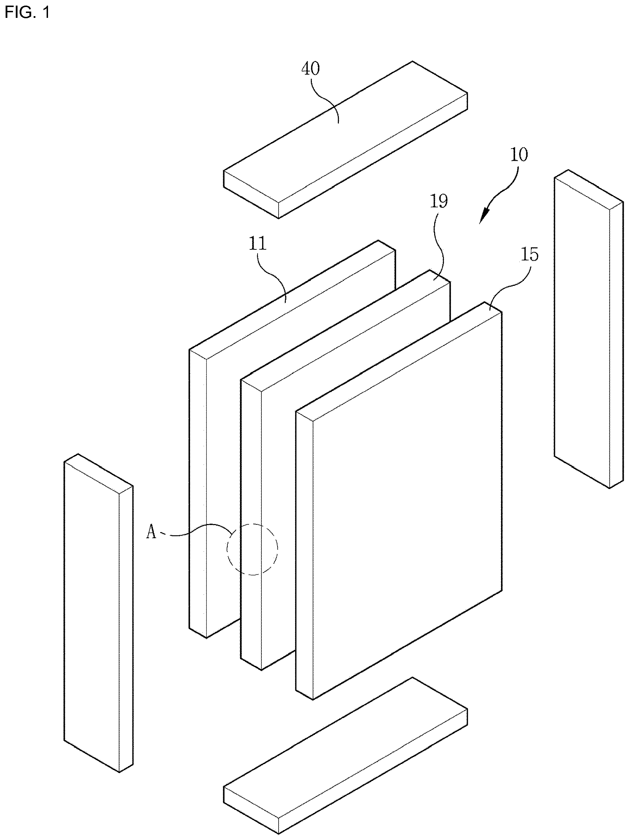

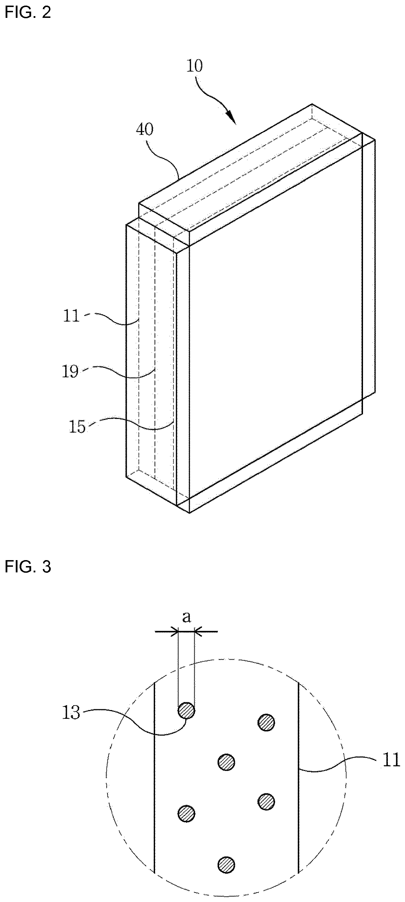

FIG. 1 is an exploded view of a fluorescent projection display device capable of photovoltaic generation according to an embodiment of the present disclosure, FIG. 2 is a perspective view of the fluorescent projection display device capable of photovoltaic generation of FIG. 1, and FIG. 3 is an enlarged view of a portion A in FIG. 1.

Referring to FIGS. 1-3, the fluorescent projection display device 10 according to the present embodiment includes a transparent film 19 and a solar cell 40. The fluorescent projection display device 10 may further include a transparent substrate 11 or 15 disposed on at least one surface of the transparent film 19 to support the transparent film 19.

Although the projection display device 10 is shown as including the transparent substrates 11 and 15 in the drawings, the projection display device 10 does not necessarily have to include the transparent substrates 11 and 15. In the following description, it is assumed that transparent substrates 11 and 15 are provided in the projection display device 10.

The transparent film 19 is doped with luminescent molecules 13 that absorb incoming light with a excitation wavelength range and re-emit visual light.

Such a transparent film 19 may be formed by dispersing a nano-sized luminescent materials in a transparent plastic material. The transparent plastic material may be composed of at least one of various materials including inorganic materials and organic materials. For example, poly-methyl-methacrylate (PMMA) which is a transparent polymer resin may be used for the transparent plastic material. Preferably, the transparency of the transparent plastic material may be 80% or more.

The transparent film 19 may be formed by coating the transparent polymer resin embedding the nano-sized luminescent materials on the transparent substrates 11 and 15. However, the present disclosure is not limited thereto, and the transparent film 19 may be made, by injection molding or the like, for example, by use of a polymer composite material that can maintain its shape without the assistance of the transparent substrates 11 and 15.

To summarize, the transparent film 19 is a composite transparent film in which the luminescent materials 13 are embedded in the transparent plastic material.

Here, the luminescent materials 13 are excitated by light in a wavelength range other than a visible light range of 420-650 nanometers and emits light in the visible light range of 420-650 nanometers. It is preferable that the luminescent materials 13 have sizes (a) of 50 nanometers or less, since scattering of light may occur at the luminescent materials 13 when the size of the luminescent materials 13 exceed 50 nm. The luminescent materials 13 may include semiconductor nano-sized crystalline particles.

For example, quantum dots may be used as the semiconductor nano-sized crystalline particles.

Meanwhile, the luminescent materials 13 scatters incident sunlight. When the sunlight is incident from outside, photons collides with the luminescent materials 13 and to be scattered in the transparent film 19. Some of the incident sunlight and the scattered sunlight is reflected on the internal surface of the transparent film 19. The reflected light may be totally reflected several times internally in the transparent film 19 due to a difference in refractive indices between the transparent film 19 and air, and moves inside the transparent film 19 to the edge of the transparent film 19. The sunlight totally reflected internally in the transparent film 19 is incident on and trapped by the solar cell 40 located at the edge of the transparent film 19 and converted to electricity.

The transparent film 19 may have a transmittance of 30% or higher and a haze of 3% or less. Also, a concentration factor of the transparent film 19 can be changed by adjusting the quantity and size of the luminescent materials 13 in the transparent film 19.

On the other hand, the transparent substrates 11 and 15 are colorless and transparent preferably. However, the present disclosure is not limited thereto, and the transparent substrates 11 and 15 may be colored films while maintaining their transparency. These transparent substrates which includes a first transparent substrate 11 and a second transparent substrate 15 attached on respective sides of the transparent film 19 may support and protect the transparent film 19.

The solar cell 40 is disposed to at least one edge of the transparent film 19 and the transparent substrates 11 and 15 in the projection display device 10 according to the present embodiment.

Preferably, the solar cell 40 may be attached to an edge having the largest area among the four edges of the transparent film 19 and the transparent substrate 11, 15. However, the present disclosure is not limited thereto, and the solar cell 40 may be attached to all the four edges, for example.

For example, the solar cell 40 may be a thin film solar cell, a compound semiconductor solar cell, a dye-sensitized solar cell (DSSC), or an organic photovoltaic cell (OPV).

In case that a plurality of solar cells are installed at a plurality of edges of the transparent film 19 and the transparent substrates 11 and 15, the plurality of solar cells may be connected in series so as to increase an output voltage that may be used practically.

As described above, the fluorescent projection display device 10 according to the present disclosure includes the transparent film 19 doped with luminescent materials that scatter sunlight and are excited by the light in the excitation wavelength range to emit visible light, and the solar cell 40 disposed at the edge of the film 19. Thus, the fluorescent projection display device 10 according to the present disclosure may perform both the functions of generating electricity by photovoltaic generation and displaying images.

The fluorescent projection display device capable of photovoltaic generation according to the present disclosure can be used as a window-attachable solar cell because it is transparent and capable of generate photovoltaic electric energy.

In such a case, the functional versatility and utility of the fluorescent projection display device capable of photovoltaic generation according to the present disclosure can be extended to three types of devices: a transparent window, a photovoltaic energy generation device, and a display device that may be used to display a transparent augmented reality image.

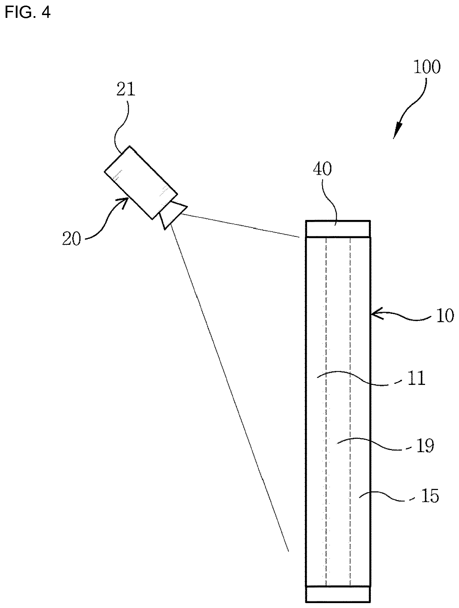

A display system employing the fluorescent projection display device capable of photovoltaic generation according to the present embodiment will now be described with reference to FIG. 4.

FIG. 4 schematically illustrates a display system employing the fluorescent projection display device capable of photovoltaic generation according to an embodiment of the present disclosure.

The display system 100 according to the present embodiment includes a fluorescent projection display device 10 capable of photovoltaic generation and a projector 20 that illuminates a projection beam on at least one surface of the fluorescent projection display device 10.

The projector 20 radiates the projection beam having a wavelength range that may excitate the fluorescent projection display device 10 so that the fluorescent projection display device 10 displays an image corresponding to the projection beam.

Here, a light source of the projector 20 that emits the projection beam may be an light emitting diode (LED) or a laser projector. The light generated by the light source may be in a wavelength range below 420 nm which is lower than the wavelength of the visible light.

In addition, the projector 20 includes an image forming device such as a digital light processing (DLP) processor laid out on a digital micro-mirror device (DMD) or a Galvano scanner.

In this specification including the claims, the term "luminescent materials" may be a synonym of "fluorescent materials". The term "luminescent materials" does not necessarily mean a plurality kinds of luminescent materials are present in the transparent film 19 even though the term is used in plural form. The "luminescent materials" may mean luminescent particles, but the luminescent materials are not limited to solid state materials.

## Claims

1. A fluorescent projection display device (10) capable of photovoltaic generation, comprising:
a transparent film (19) including luminescent materials (13) configured to reflect incident sunlight internally to concentrate the incident sunlight, and to be excitated by input light in an excitation wavelength range to radiate a display light corresponding to the light in the excitation wavelength range, wherein the luminescent materials (13) are configured to emit visible light as the display light; and
a solar cell (40) disposed on at least one edge of the transparent film (19) to convert concentrated sunlight propagated from the transparent film (19) into electricity.

2. The fluorescent projection display device of claim 1, further comprising:
a transparent substrate (11, 15) disposed on at least one side of the transparent film (19) to support the transparent film.

3. The fluorescent projection display device of claim 2, wherein the luminescent materials (13) have sizes of 50 nanometers or smaller and an emission wavelength range of 420-650 nanometers or narrower.

4. The fluorescent projection display device of claim 2, wherein the transparent film (19) has a transmittance of 30% or higher and a haze of 3% or less.

5. A fluorescent projection display system (100) capable of photovoltaic generation, comprising:
a fluorescent projection display device (10) comprising a transparent film (19) including luminescent materials (13) configured to reflect incident sunlight internally to concentrate the incident sunlight, and to be excitated by input light in an excitation wavelength range to radiate a display light corresponding to the light in the excitation wavelength range, wherein the luminescent materials (13) are configured to emit visible light as the display light, and a solar cell (40) disposed on at least one edge of the transparent film (19) to convert concentrated sunlight propagated from the transparent film into electricity; and
a projector (20) configured to radiate a projection beam the excitation wavelength range to the fluorescent projection display device (10) so that the fluorescent projection display device displays an image corresponding to the projection beam.

6. The fluorescent projection display system of claim 5, wherein the excitation wavelength range is below 420 nm.

7. The fluorescent projection display system of claim 6, wherein the projector comprises a light emitting diode or a laser projector as a light source.

8. The fluorescent projection display system of claim 7, wherein the projector comprises a digital light processing (DLP) processor or a Galvano scanner as an image forming device.

## Patentansprüche

1. Fluoreszenzprojektion-Anzeigevorrichtung (10), die zu einer Photovoltaikerzeugung in der Lage ist, umfassend:
einen transparenten Film (19), der Leuchtstoffe (13) aufweist, die eingerichtet sind, um einfallendes Sonnenlicht intern zu reflektieren, um das einfallende Sonnenlicht zu konzentrieren, und um durch Eingangslicht in einem Erregungswellenlängenbereich erregt zu werden, um ein Anzeigelicht auszustrahlen, das dem Licht in dem Erregungswellenlängenbereich entspricht, wobei die Leuchtstoffe (13) eingerichtet sind, um sichtbares Licht als Anzeigelicht zu emittieren; und
eine Solarzelle (40), die auf mindestens einem Rand des transparenten Films (19) angeordnet ist, um konzentriertes Sonnenlicht, das von dem transparenten Film (19) verbreitet wird, in Elektrizität umzuwandeln.

2. Fluoreszenzprojektion-Anzeigevorrichtung nach Anspruch 1, ferner umfassend:
ein transparentes Substrat (11, 15), das auf mindestens einer Seite des transparenten Films (19) angeordnet ist, um den transparenten Film zu tragen.

3. Fluoreszenzprojektion-Anzeigevorrichtung nach Anspruch 2, wobei die Leuchtstoffe (13) Größen von 50 Nanometern oder kleiner und einen Emissionswellenlängenbereich von 420-650 Nanometern oder schmaler aufweisen.

4. Fluoreszenzprojektion-Anzeigevorrichtung nach Anspruch 2, wobei der transparente Film (19) eine Durchlässigkeit von 30 % oder mehr und eine Trübung von 3% oder weniger aufweist.

5. Fluoreszenzprojektion-Anzeigesystem (100), das zu einer Photovoltaikerzeugung in der Lage ist, umfassend:
eine Fluoreszenzprojektion-Anzeigevorrichtung (10), umfassend einen transparenten Film (19), der Leuchtstoffe (13) aufweist, die eingerichtet sind, um einfallendes Sonnenlicht intern zu reflektieren, um das einfallende Sonnenlicht zu konzentrieren, und um durch Eingangslicht in einem Erregungswellenlängenbereich erregt zu werden, um ein Anzeigelicht auszustrahlen, das dem Licht in dem Erregungswellenlängenbereich entspricht, wobei die Leuchtstoffe (13) eingerichtet sind, um sichtbares Licht als Anzeigelicht zu emittieren, und eine Solarzelle (40), die auf mindestens einem Rand des transparenten Films (19) angeordnet ist, um konzentriertes Sonnenlicht, das von dem transparenten Film verbreitet wird, in Elektrizität umzuwandeln; und
einen Projektor (20), der eingerichtet ist, um eine Fluoreszenzprojektion-Anzeigevorrichtung (10) mit einem Projektionsstrahl in dem Erregungswellenlängenbereich zu bestrahlen, so dass die Fluoreszenzprojektion-Anzeigevorrichtung ein Bild entsprechend dem Projektionsstrahl anzeigt.

6. Fluoreszenzprojektion-Anzeigesystem nach Anspruch 5, wobei der Erregungswellenlängenbereich unter 420 nm liegt.

7. Fluoreszenzprojektion-Anzeigesystem nach Anspruch 6, wobei der Projektor eine Leuchtdiode oder einen Laserprojektor als Lichtquelle umfasst.

8. Fluoreszenzprojektion-Anzeigesystem nach Anspruch 7, wobei der Projektor einen digitalen lichtverarbeitenden (DLB) Prozessor oder einen Galvanoscanner als Bilderzeugungsvorrichtung umfasst.

## Revendications

1. Dispositif d'affichage fluorescent par projection (10) capable de génération photovoltaïque, comprenant :
un film transparent (19) incluant des matières luminescentes (13) configurées pour réfléchir une lumière du soleil incidente à l'intérieur pour concentrer la lumière du soleil incidente, et pour être excitées par une lumière d'entrée dans une plage de longueurs d'onde d'excitation pour rayonner une lumière d'affichage correspondant à la lumière dans la plage de longueurs d'onde d'excitation, dans lequel les matières luminescentes (13) sont configurées pour émettre de la lumière visible en tant que lumière d'affichage ; et
une pile solaire (40) disposée sur au moins un bord du film transparent (19) pour convertir une lumière du soleil concentrée qui s'est propagée depuis le film transparent (19) en électricité.

2. Dispositif d'affichage fluorescent par projection selon la revendication 1, comprenant en outre :
un substrat transparent (11, 15) disposé sur au moins une face du film transparent (19) pour supporter le film transparent.

3. Dispositif d'affichage fluorescent par projection selon la revendication 2, dans lequel les matières luminescentes (13) ont des tailles de 50 nanomètres ou moins et une plage de longueurs d'onde d'émission de 420 à 650 nanomètres ou moins.

4. Dispositif d'affichage fluorescent par projection selon la revendication 2, dans lequel le film transparent (19) a une transmittance de 30 % ou plus et un trouble de 3 % ou moins.

5. Système d'affichage fluorescent par projection (100) capable de génération photovoltaïque, comprenant :
un dispositif d'affichage fluorescent par projection (10) comprenant un film transparent (19) incluant des matières luminescentes (13) configurées pour réfléchir une lumière du soleil incidente à l'intérieur pour concentrer la lumière du soleil incidente, et pour être excitées par une lumière d'entrée dans une plage de longueurs d'onde d'excitation pour rayonner une lumière d'affichage correspondant à la lumière dans la plage de longueurs d'onde d'excitation, dans lequel les matières luminescentes (13) sont configurées pour émettre une lumière visible en tant que lumière d'affichage, et une pile solaire (40) disposée sur au moins un bord du film transparent (19) pour convertir une lumière du soleil concentrée qui s'est propagée depuis le film transparent en électricité ; et
un projecteur (20) configuré pour rayonner un faisceau de projection dans la plage de longueurs d'onde d'excitation jusqu'au dispositif d'affichage fluorescent par projection (10) de sorte que le dispositif d'affichage fluorescent par projection affiche une image correspondant au faisceau de projection.

6. Système d'affichage fluorescent par projection selon la revendication 5, dans lequel la plage de longueurs d'onde d'excitation est inférieure à 420 nm.

7. Système d'affichage fluorescent par projection selon la revendication 6, dans lequel le projecteur comprend une diode électroluminescente ou un projecteur laser en tant que source de lumière.

8. Système d'affichage fluorescent par projection selon la revendication 7, dans lequel le projecteur comprend un processeur à traitement numérique de la lumière (DLP) ou un dispositif de balayage Galvano en tant que dispositif de formation d'image.
